# EUROPÄISCHE PATENTSCHRIFT

(11) **EP 1 627 455 B1**
(45) Veröffentlichungstag und Bekanntmachung des Hinweises auf die Patenterteilung: **02.12.2009**
(21) Anmeldenummer: 04738555.4
(22) Anmeldetag: 26.05.2004
(51) Int. Cl.: H01S 5/022, H01S 5/024

(54) **GEHÄUSE FÜR EIN LASERDIODENBAUELEMENT UND LASERDIODENBAUELEMENT**
HOUSING FOR A LASER DIODE COMPONENT, AND LASER DIODE COMPONENT ITSELF
BOITIER POUR COMPOSANT A DIODES LASER, ET COMPOSANT A DIODES LASER Y RELATIF

(30) Priorität: 26.05.2003 DE 10323857
(43) Veröffentlichungstag der Anmeldung: 22.02.2006
(73) Patentinhaber: OSRAM Opto Semiconductors GmbH, 93055 Regensburg (DE)
(72) Erfinder: FERSTL, Christian, 93073 Neutraubling (DE); GRÖTSCH, Stefan, 93077 Lengfeld/Bad Abbach (DE); ZEILER, Markus, 93152 Nittendorf (DE)
(74) Vertreter: Epping - Hermann - Fischer
(86) Internationale Anmeldenummer: PCT/DE2004/001086
(87) Internationale Veröffentlichungsnummer: WO 2004/107511

(56) Entgegenhaltungen:
- WO-A-00/57522
- DE-A- 10 117 890
- JP-A- 2002 111 066
- US-A- 5 999 552
- US-B1- 6 449 296
- US-B1- 6 487 224
- PATENT ABSTRACTS OF JAPAN Bd. 1998, Nr. 05, 30. April 1998 (1998-04-30) -& JP 10 022576 A (MITSUBISHI ELECTRIC CORP), 23. Januar 1998 (1998-01-23)

## Beschreibung

Die Erfindung betrifft ein Laserdiodenbauelement und einen Laser-Scheinwerfer mit einer Mehrzahl von Laserdiodenbauelementen.

Die vorliegende Patentanmeldung nimmt die Priorität der Deutschen Patentanmeldung mit dem Aktenzeichen 103 23 857.3 (Prioritätsdatum: 26.05.2003) in Anspruch.

Laserdiodenbauelemente werden herkömmlich in der Regel mit technisch aufwändigen Metallgehäusen hergestellt oder anderweitig technisch aufwändig eingekapselt, wie es beispielsweise in der US 5,226,052 beschrieben ist.

Die Druckschrift DE 101 17 890 A1 betrifft ein Verfahren zur Herstellung eines strahlungsempfangenden und/oder emittierenden Halbleiterbauelements und ein solches Halbleiterbauelement.

In der Druckschrift JP 10-022576 A ist ein Halbleiterbauelement angegeben.

Eine Laserdiodenanordnung ist in der Druckschrift US 6,487,224 B1 offenbart.

Ein Halbleiterlaserbauteil ist ferner in der Druckschrift US 6,449,296 B1 beschrieben.

Die Druckschrift WO 00/57522 A1 betrifft ein VCSEL-Leistungsmesssystem, bei dem eine Kunststoffverkapselungsmethode eingesetzt wird.

In der Druckschrift US 5,999,552 A ist eine Strahlung emittierende Komponente offenbart.

Ein optisches Halbleiterbauteil findet sich in der Druckschrift JP 2002-111066 A.

Es ist Aufgabe der vorliegenden Erfindung, ein Laserdiodenbauelement anzugeben, das einen in einem oberflächenmontierbaren Gehäuse vormontierbaren, kantenemittierenden Halbleiterlaserchip umfasst. Eine weitere zu lösende Aufgabe besteht darin, einen Laser-Scheinwerfer mit einem solchen Laserdiodenbauelement anzugeben.

Diese Aufgabe wird durch ein Laserdiodenbauelement mit den Merkmalen des Anspruches 1 gelöst sowie durch einen Laser-Scheinwerfer mit den Merkmalen des Anspruches 19. Vorteilhafte Ausführungsformen und Weiterbildungen des Laserdiodenbauelements ergeben sich aus den abhängigen Ansprüchen 2 bis 18.

Der Offenbarungsgehalt der Patentansprüche 1 und 19 wird hiermit ausdrücklich in diese Beschreibung aufgenommen.

Bei einem Laserdiodenbauelement mit einem oberflächenmontierbaren Gehäuse gemäß der Erfindung ist der Gehäusegrundkörper aus einem Material gefertigt, das für eine vom Laserdiodenbauelement auszusendende Laserstrahlung durchlässig ist, und einen Chipmontagebereich umfaßt, und verläuft eine Strahlachse des Laserdiodenbauelements durch den Gehäusegrundkörper. Das für die Läserstrahlung durchlässige Material des Gehäusegrundkörpers ermöglicht einen Verzicht auf die Umlenkung des vom Laserchip emittierten Laserstrahls. Der emittierte Laserstrahl wird unmittelbar durch eine Gehäusewand des Gehäusegrundkörpers transmittiert.

Weiterhin verläuft eine Strahlachse des Laserdiodenchips schräg entlang oder im wesentlichen parallel entlang zu einer durch den Chipmontagebereich definierten Ebene. Der Laserdiodenchip ist ein kantenemittierender Laserdiodenchip.

Bei der Herstellung des Gehäusegrundkörpers, welches beispielsweise durch Umspritzen eines metallischen Leiterrahmens mit einer Formmasse geschieht, wird eine strahlungsdurchlässige Formmasse verwendet. Während bei konventionellen Gehäusen Maßnahmen zur Umlenkung des emittierten Lichtstrahls getroffen werden müssen, entfällt dies bei diesem erfindungsgemäßen Gehäuse im Wesentlichen vollständig. Nachfolgend wird der Laserdiodenchip in den Chipmontagebereich des Gehäusegrundkörpers montiert, elektrische Kontakte des Laserdiodenchips mit den elektrischen Anschlußleitern verbunden und der Laserdiodenchips mit einer Umhüllungsmasse umhüllt.

Bei dem Gehäuse dient die Ausnehmung in erster Linie zur Aufnahme des Laserdiodenchips und zu dessen elektrischem Anschluss. Eine weitergehende optische Funktion hat die Ausnehmung vorliegend nicht zu erfüllen. Die die Ausnehmung begrenzenden Seitenwände können aber in Teilbereichen, durch die keine Laserstrahlung austreten soll, absorbierend, reflexive oder streuende Eigenschaften aufweisen.

Bei dem oben beschriebenen Gehäuse verläuft die Strahlachse vorzugsweise im wesentlichen parallel zu einer Chipmontagefläche im Chipmontagebereich. Dies hat zur Folge, dass beispielsweise bei einem Gehäusegrundkörper, bei dem eine der Seitenflächen als Montagefläche (das heißt als Auflagefläche beispielsweise auf einer Leiterplatte) dient, eine Strahlachse senkrecht zur Montageebene, beispielsweise einer Leiterplatte, erzielt werden kann.

Bevorzugt ist der Gehäusegrundkörper aus einer transparenten Formmasse, insbesondere aus einem transparenten Kunststoff gebildet. Es ist besonders bevorzugt, wenn die Formmasse zumindest kurzzeitig temperaturbeständig bis ca. 260°C ist. Hierdurch ist sichergestellt, dass die kurzfristig auftretenden Temperaturbelastungen eines Lötprozesses (üblicherweise entstehen hierbei Temperaturen bis zu 260°C) das Gehäuse weitestgehend unbeschädigt belassen.

In einer bevorzugten Ausgestaltung enthält der Kunststoff Polyethersulfon (PES). Dieses Material ist auch unter dem Namen Ultrason bekannt.

Gemäß einer weiteren bevorzugten Ausgestaltung des Gehäuses ist zumindest eine äußere Seitenfläche des Gehäusegrundkörpers mit einer optischen Einrichtung versehen. Hierdurch besteht die Möglichkeit, den von dem Laserdiodenchip ausgesandten Laserstrahl in eine gewünschte Richtung abzulenken. Anstatt die optische Einrichtung an einer Außenwand des Gehäusegrundkörpers vorzusehen, könnte diese ebenso in einem Montagegehäuse vorgesehen sein, in welche das Gehäuse selbst zur Montage eingebracht wird.

Bei der optischen Einrichtung könnte es sich beispielsweise um einen schräg zur Strahlachse des Laserstrahls stehenden Teilbereich der Seitenfläche des Gehäusegrundkörpers handeln, die beispielsweise allein schon durch eine Entformungsschräge erzielt wird und zur Ablenkung des Laserstrahls dient. Alternativ denkbar ist die Verwendung einer Linse zur Erzielung einer zusätzlichen Kollimation.

Um vorteilhafterweise auf herkömmliche Herstellungsprozesse aus der Leuchtdiodentechnik zurückgreifen zu können, ist bei dem erfindungsgemäßen Gehäuse in einer bevorzugten Ausgestaltung vorgesehen, dass der Chipmontagebereich und die elektrischen Anschlußleiter Bestandteile eines metallischen Leiterrahmen sind. Solche Herstellungsprozesse ergeben sich beispielsweise aus der EP 0 400 175 oder der US 6,376,902.

In einer vorteilhaften Ausgestaltung ist der Chip in dem Chipaufnahmebereich zumindest teilweise mit einer strahlungsdurchlässigen Vergussmasse, insbesondere einer Kunststoffmasse, wie einem Giessharz oder einer Pressmasse, umhüllt. Bevorzugt enthält die Kunststoffmasse eine Epoxidharz, ein Acrylharz, ein Siliconharz oder eine Mischung dieser Harze.

Es ist weiterhin vorteilhaft, wenn die Materialien der Vergussmasse und des Gehäusegrundkörpers hinsichtlich ihrer Brechungsindizes aneinander angepasst sind. Dies gilt auch dann, wenn die optische Einrichtung nicht in einer Außenwand des Gehäusegrundkörpers, sondern in einem Montagegehäuse vorgesehen ist, in welches das Gehäuse und damit der Gehäusegrundkörper eingesetzt wird. In diesem Falle müssen die Brechungsindizes vom Gehäusegrundkörper und Montagegehäuse aneinander angepasst sein. Es versteht sich von selbst, das das Montagegehäuse, welches eine optische Einrichtung enthält, in diesem Bereich transparent ist.

Bei einem anderen bevorzugten Gehäuse gemäß einer Abwandlung der Erfindung ist am Gehäusegrundkörper, vorzugsweise in einer Ausnehmung des Gehäusegrundkörpers, in der sich der Chipmontagebereich befindet, im Unterschied zu dem vorangehend beschriebenen bevorzugten oberflächenmontierbaren Gehäuse und dessen vorteilhaften Ausführungsformen und Weiterbildungen ein Strahlumlenkelement, beispielsweise ein Spiegelelement, angeordnet, der den Laserstrahl des Laserdiodenchips derart umlenkt, dass er den Gehäusegrundkörper nicht durchstrahlt. Der Gehäusegrundkörper kann dann vorzugsweise aus einem weitgehend strahlungsundurchlässigen oder nicht gut strahlungsdurchlässigen Material gefertigt sein und hinsichtlich anderer Parameter als Strahlungsdurchlässigkeit, wie beispielsweise thermische Beständigkeit, optimiert sein. Vorzugsweise befindet sich im Gehäusegrundkörper ein thermisch gut leitender Chipmontagesockel, der vorzugsweise von außerhalb des Gehäusegrundkörpers, bevorzugt von einer Rückseite oder alternativ von einer Seitenfläche des Gehäusegrundkörpers her, thermisch anschließbar ist.

Ein bevorzugtes Verfahren zum Herstellen eines Laserdiodenbauelements gemäß der Erfindung umfaßt die folgenden Verfahrensschritte:
- Bereitstellen eines metallischen Leiterrahmens mit den elektrischen Anschlußleitern,
- Umformen eines Teilbereiches des Leiterrahmens einschließlich Teilbereichen der elektrischen Anschlußleiter mit dem Gehäusegrundkörper,
- Montieren des Laserdiodenchips in den Chipmontagebereich des Gehäusegrundkörpers,
- Elektrisches Verbinden der elektrischen Kontakte des Laserdiodenchips mit den elektrischen Anschlußleitern und
- Umhüllen des Laserdiodenchips mit der Umhüllungsmasse.

Bei einer vorteilhaften Ausführungsform des Verfahrens wird vor dem Umformen des Leiterrahmens mit dem Gehäusegrundkörper dem Leiterrahmen ein thermisch gut leitender Chipmontagesockel zugeordnet wird, auf dem nachfolgend der Laserdiodenchip befestigt wird und der von außerhalb des Gehäusegrundkörpers thermisch anschließbar ist. Derartige Gehäusebauformen sind prinzipiell beispielsweise in der WO 02/084749 und in der DE 101 17 890 beschrieben.

Ein Gehäuse gemäß der Erfindung ermöglicht bei der Herstellung von Laserdiodenbauelementen vorteilhafterweise den Einsatz von Verfahren, die aus der Leuchtdiodentechnik bekannt sind und dort verwendet werden. Hierbei wird ein vorgehäustes Bauteil dadurch hergestellt, dass ein vorgefertigter metallischer Leiterrahmen (Leadframe) mit einem geeigneten diffus reflektierenden Kunststoffmaterial umspritzt wird. Der dabei hergestellte Kunststoff-Formkörper weist eine Ausnehmung zum Leiterrahmen hin auf. In dieser Ausnehmung wird auf den Leiterrahmen ein Leuchtdiodenchip montiert und elektrisch mit nach außen führenden elektrischen Anschlußleitern verbunden. Der Leuchtdiodenchip wird nachfolgend mit einer transparenten Vergussmasse vergossen. Derartige Gehäuse-Bauformen sind beispielsweise aus F. Möllmer und G. Waitl, SIEMENS SMT-TOPLED für die Oberflächenmontage, Siemens Components 29 (1991), Heft 4, Seiten 147-149, bekannt. Ähnliche Gehäuse für Leuchtdiodenbauelemente sind weiterhin aus der WO 02/084749 A2 bekannt .

Ein Gehäuse gemäß einer Abwandlung der Erfindung mit strahlungsdurchlässigem Gehäusegrundkörper und ohne Strahlumlenkelement lässt sich vorteilhafterweise nicht nur für kantenemittierende Laserdiodenchips einsetzen, sondern ist auch geeignet für andere insbesondere kantenemittierende strahlungsemittierende Halbleiterchips, wie beispielsweise Leuchtdiodenchips.

Ein Verfahren zum Herstellen eines Laserdiodenbauelements mit einem elektrisch isolierenden Gehäusegrundkörper, der einen Chipmontagebereich umfaßt, mit elektrischen Anschlußleitern, die aus dem Gehäusegrundkörper herausgeführt sind und von ausserhalb des Gehäusegrundkörpers zugänglich sind, und mit einem Laserdiodenchip, der im Chipmontagebereich angeordnet ist und elektrische Kontakte aufweist, die mit den elektrischen Anschlussleitern elektrisch leitend verbunden sind, umfaßt folgende Verfahrensschritte:
- Bereitstellen eines metallischen Leiterrahmens mit den elektrischen Anschlußleitern,
- Ausbilden des Gehäusegrundkörpers mit dem Chipmontagebereich am Leiterrahmen, derart, dass die elektrischen Anschlußleiter aus diesem herausragen,
- Montieren des Laserdiodenchips in den Chipmontagebereich des Gehäusegrundkörpers,
- Elektrisches Verbinden der elektrischen Kontakte des Laserdiodenchips mit den elektrischen Anschlußleitern und
- Umhüllen des Laserdiodenchips mit einer der Umhüllungsmasse, die für eine vom Laserdiodenchip im Betrieb ausgesandte Laserstrahlung durchlässig ist.

Der Laserdiodenchip wird bei diesem Verfahren folglich auf einen sogenannten vorgehäusten (premolded) metallischen Leiterrahmen (Leadframe) montiert. Beispielsweise mittels Löten.

Bevorzugt wird im Gehäusegrundkörper ein thermisch gut leitender und im Betrieb des Laserdiodenbauelements als Wärmesenke wirkender Chipmontagesockel angeordnet. Vorzugsweise wird der Laserdiodenchip auf diesen Chipmontagesockel montiert.

Besonders bevorzugt wird dazu vor dem Umformen des Leiterrahmens mit dem Gehäusegrundkörper der Leiterrahmen mit einem thermisch gut leitenden und im Betrieb des Laserdiodenbauelements als Wärmesenke wirkenden Chipmontagesockel versehen, auf dem nachfolgend der Laserdiodenchip thermisch leitend befestigt wird und der von der Rückseite des Laserdiodenbauelements her thermisch anschließbar ist.

Vorzugsweise wird dazu vor dem Umformen des Leiterrahmens mit dem Gehäusegrundkörper der Leiterrahmen mit einem thermisch gut leitenden und im Betrieb des Laserdiodenbauelements als Wärmesenke wirkenden Chipmontagesockel versehen, auf dem nachfolgend der Laserdiodenchip thermisch leitend befestigt wird und der derart mit dem Gehäusegrundkörper umformt wird, dass er an dessen Rückseite zumindest teilweise freiliegt und dort thermisch anschließbar ist.

Der Gehäusegrundkörper ist vorteilhafterweise aus einem Kunststoffmaterial gefertigt. Bevorzugt wird dazu ein Kunststoffmaterial auf der Basis von Epoxidharz oder Acrylharz verwendet.

Als Umhüllungsmasse des Laserdiodenchips wird bevorzugt ein Kunststoffmaterial auf Silikon-Basis verwendet.

Bei einer besonders bevorzugten Ausgestaltung des Verfahrens wird im Gehäusegrundkörper eine Ausnehmung ausgebildet, an oder in der sich der Chipmontagebereich und Anschlußbereiche der elektrischen Anschlußleiter befinden und in der der Leuchtdiodenchip angeordnet wird.

Bei einer weiterhin vorteilhaften Ausführungsform des Verfahrengestaltung wird in der Ausnehmung ein Laserdiodenchip angeordnet, dessen Strahlachse schräg entlang oder im wesentlichen parallel entlang zu einer Chipmontagefläche des Chipmontagebereichs definierten Ebene verläuft, und ist in der Ausnehmung in der Strahlachse des Laserdiodenchips ein Strahlumlenkelement, beispielsweise ein Spiegelelement, angeordnet, das geeignet ist, eine Laserstrahlung des Laserdiodenchips zur vorgesehenen Strahlachse des Laserdiodenbauelements hin umzulenken.

Das Strahlumlenkelement wird vorzugsweise derart schrägstehend zur Strahlachse des Laserdiodenchips angeordnet, dass die Strahlachse des Laserdiodenbauelements im Wesentlichen senkrecht zu der durch die Chipmontagefläche definierten Ebene verläuft. Zur einfacheren Positionierung und Befestigung des Spiegelelements wird an einer Seitenwand der Ausnehmung eine schräg zur Strahlachse des Laserdiodenchips stehende ebene Fläche ausgebildet, an der nachfolgend das Spiegelelement befestigt wird.

Die Anschlußleiter können auf einfache Weise derart geformt werden, dass das Laserdiodenbauelement oberflächenmontierbar ist.

Weitere Vorteile, vorteilhafte Merkmale, Vorzüge und Zweckmäßigkeiten der Erfindung werden anhand der nachfolgenden Ausführungsbeispiele in Verbindung mit den Figuren erläutert. Es zeigen:
- Figur 1: eine schematische Darstellung eines ersten Ausführungsbeispieles eines Laserdiodenbauelements in einer Seitenansicht,
- Figur 2: eine schematische Darstellung des Ausführungsbeispieles von Figur 1 in einer Draufsicht,
- Figur 3: eine schematische Darstellung eines weiteren Ausführungsbeispieles eines Laserdiodenbauelements mit einem Montagegehäuse in einer Seitenansicht, und
- Figur 4a bis 4d: eine schematische Darstellung eines Verfahrensablaufes zur Herstellung eines oberflächemontierbaren Laserdiodenbauelements gemäß eines nicht zur Erfindung gehörenden Ausführungsbeispiels.

In den Ausführungsbeispielen und den zugehörigen Figuren sind gleiche oder gleichwirkende Bestandteile jeweils mit den gleichen Bezugszeichen versehen. Die Zeichnungen der Figuren sind nicht als maßstabsgerecht anzusehen.

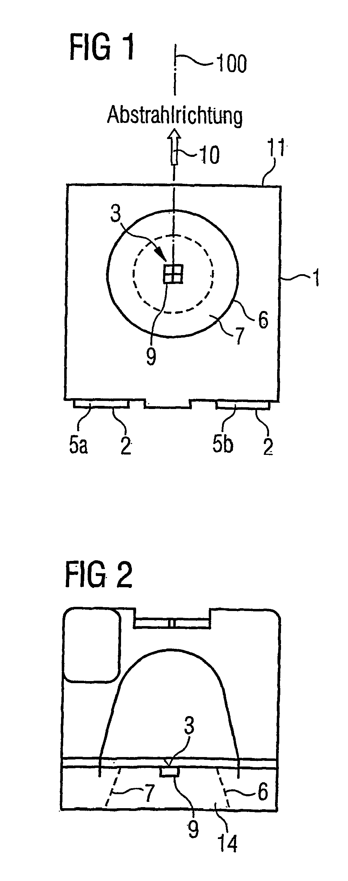

Das Gehäuse des in den Figuren 1 und 2 dargestellten Ausführungsbeispieles eines Laserdiodenbauelements weist einen Gehäusegrundkörper 1 auf, aus dem an einer Seite, hier die Montageseite des Baulements, elektrische Anschlussleiter 5a,5b in Form von Anschlussstreifen herausgeführt sind. Die Anschlussleiter 5a,5b sind Teil eines metallischen Leiterrahmens 2 (Leadframe), an den der Gehäusegrundkörper 1 angeformt ist und der ins Innere des Gehäusegrundkörpers geführt ist. Zur Herstellung des Gehäusegrundkörpers 1 wird beispielsweise, wie weiter oben bereits beschrieben, an den Leiterrahmen 2 eine Spritz- oder Pressform mit einer Kavität für den Gehäusegrundkörper 2 angelegt und in die Kavität eine Formmasse eingespritzt, so dass die gewünschte Form des Gehäusegrundkörpers entsteht. Solche Gehäusebauformen, bei denen der Gehäusegrundkörper vor Montage des Chips an das Leadframe gespritzt oder gepresst wird, werden beispielsweise als premold-Gehäuse bezeichnet.

Der Gehäusegrundkörper 1 besteht beispielweise aus einem transparenten Material, insbesondere einem transparenten Kunststoff, vorzugsweise aus Polyethersulfon PES. Dies bedeutet nichts anderes, als dass der gesamte Gehäusegrundkörper 1 für die von einem Laserdiodenchip 9, der zur Montage in dem Gehäusegrundkörper 1 vorgesehen ist, emittierte,Laserstrahlung durchlässig ist. Für ein Infrarot-Laserdiodenbauelement muss der Kunststoff des Gehäusegrundkörpers 1 nicht unbedingt durchsichtig sein. Er muss lediglich die emittierte infrarote Laserstrahlung durchlassen.

Der Gehäusegrundkörper 1 weist von einer Seitenfläche her zum Leiterrahmen 2 hin eine Ausnehmung oder Kavität 6 auf, die beispielhaft von außerhalb gesehen mit einem runden Querschnitt ausgeführt ist. Der Querschnitt kann grundsätzlich auch eine beliebige andere Form aufweisen.

An die Ausnehmung 6 des Gehäusegrundkörpers 1 grenzen ein Chipmontagebereich 3 und elektrische Anschlußbereiche des Leiterrahmens 2, so dass diese nach dem Umformen des Leiterrahmens 2 mit dem Gehäusegrundkörper 1 von außerhalb zur Montage und zum elektrischen Anschliessen des Laserdiodenchips 9 durch die Ausnehmung 6 hindurch zugänglich ist.

Bei einem fertigen Laserdiodenbauelement ist auf dem Chipmontagebereich 3 ein Laserdiodenchip 9 mittels eines elektrisch leitenden Verbindungsmaterials mechanisch befestigt. Das Verbindungsmaterial stellt eine elektrisch leitende Verbindung zwischen einem unterseitigen elektrischen Kontakt des Laserdiodenchips 9 und dem Chipmontagebereich 3 her, der mit dem ersten der beiden elektrischen Anschlussleiter 5a,5b elektrisch leitend verbunden ist. Ein oberseitiger elektrischer Kontakt des Laserdiodenchips 9 ist beispielsweise über eine Drahtverbindung (nicht gezeigt) mit dem zweiten der beiden Anschlussstreifen 5a,5b elektrisch verbunden ist.

Der Boden der Ausnehmung kann beispielsweise eine im Vergleich zur Öffnung an der Hauptfläche des Gehäusegrundkörpers kleinere Fläche aufweisen, so dass eine gegenüber dem Gehäuseboden geneigte Seitenwand 7 gebildet ist. In dem Bereich der Seitenwand 7, der zur Einkopplung des Laserstrahls eines Laserdiodenchips 9 in den Gehäusegrundkörper 1 vorgesehen ist, kann die Seitenwand senkrecht zur Strahlachse 100 des Laserstrahls stehen.

Die Strahlachse des Laserdiodenbauelements ist in der Figur 1 durch den Pfeil 10 dargestellt. Die Strahlachse 10 liegt somit in der Blattebene. Dies ergibt sich daraus, dass die von dem Chip 9 emittierte Strahlung nach dem Auftreffen auf die Seitenwand 7 nicht umgelenkt, sondern durch diese hindurch tritt.

Der in der Ausnehmung 6 angeordnete Laserdiodenchip 9 ist mit einer strahlungsdurchlässigen Vergussmasse, insbesondere einer Kunststoffmasse, wie beispielsweise einem Giessharz oder einer Pressmasse umhüllt. Die Kunststoffmasse kann beispielsweise Epoxidharz, Silikon oder PMMA enthalten.

Die Brechungsindizes der strahlungsdurchlässigen Vergussmasse und des transparenten Gehäusegrundkörpers sind vorzugsweise aneinander angepasst, das heißt gleich oder zumindest sehr ähnlich. Dadurch können Reflexionen im Gehäuse reduziert werden.

Üblicherweise wird der Gehäusegrundkörper 1 mit seinen Anschlussstreifen 5a,5b auf eine Leiterplatte montiert. Die Anschlussstreifen 5a,5b liegen bei dem Bauelement gemäß Figur 1 an einer Seitenfläche des Gehäusegrundkörpers 1. Die Strahlachse 10 dieses Bauelementes verläuft senkrecht zur Ebene der Leiterplatte oder eines anderen Bauelementträgers.

Der der Erfindung zugrunde liegende Gedanke besteht darin, dass die Gehäusewände des Gehäusegrundkörpers 1 den von dem Laserdiodenchip emittierten Laserstrahl nicht diffus streuen oder reflektieren, sondern dass diese strahlungsdurchlässig sind. Der Strahl kann somit das Gehäuse ohne eine Umlenkung verlassen.

Um eine eventuelle unerwünschte Abstrahlung durch Seitenflächen des Gehäusegrundkörpers zu verringern, können die Seitenwände des Gehäusegrundkörpers mit einer strahlungsabsorbierenden Schicht oder einem diese Seitenwände umgebenden Montagegehäuse versehen werden.

Die Außenwand 11 kann in dem Bereich, aus dem der Laserstrahl aus dem Gehäusegrundkörper 1 auskoppelt, mit einer optischen Einrichtung, z.B. eine schräg stehende Fläche zur Umlenkung des Laserstrahles oder einer Linse zur Kollimation des Laserstrahles, versehen sein. Die schräg stehende Fläche kann beispielsweise von einer Entformungsschräge ausgebildet sein. Da eine entsprechende Anordnung und Ausgestaltung einem Fachmann ohne weiteres geläufig ist, wird auf eine detaillierte Darstellung an dieser Stelle verzichtet.

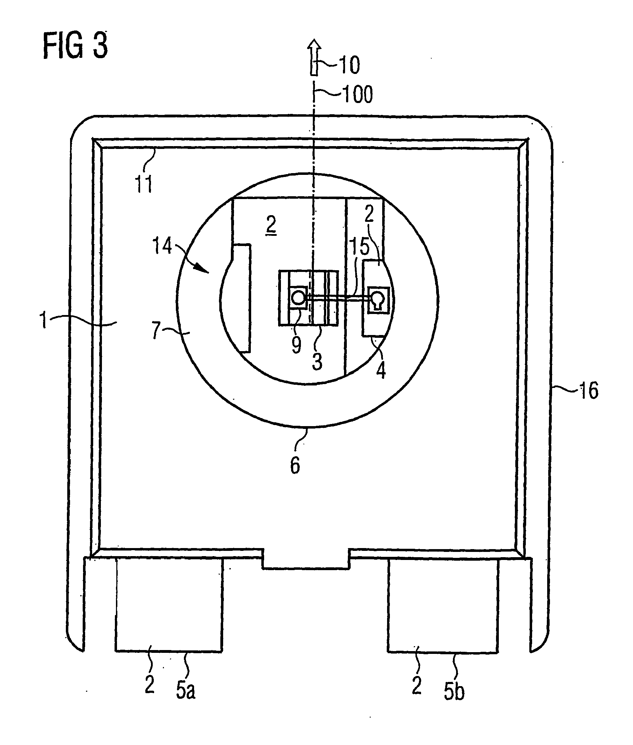

Das strahlungsemittierende Laserdiodenbauelement gemäß Figur 3 ist ähnlich dem der Figuren 1 und 2 ausgebildet. Ein Unterschied besteht insbesondere darin, dass die Anschlussstreifen 5a,5b nicht an der Gehäuseoberfläche anliegen, sondern frei liegend für eine Oberflächenmontage vorbereitet sind, bei der die Strahlachse 10 parallel zur Leiterplatte oder einem anderen Bauelementträger verläuft.

Die Ausnehmung 6 weist wiederum eine Seitenwand auf, die gegenüber dem Boden der Ausnehmung geneigt angeordnet ist. Gegenüber der abstrahlenden Seitenfläche des Laserdiodenchips 9 liegt die Seitenwand der Ausnehmung 6 jedoch parallel zur genannten Seitenfläche des Laserdiodenchips 9. Hierdurch lässt sich ein besonders guter Übergang im Grenzbereich zwischen der transparenten Vergussmasse 14, welche ebenfalls in der Ausnehmung 6 angeordnet ist und den Laserdiodenchip 9 umgibt, und dem transparenten Gehäusegrundkörper 1 erzielen.

Im Unterschied zum vorhergehenden Ausführungsbeipsiel befindet sich der Gehäusegrundkörper 1 in einem Kunststoff-Montagegehäuse 16, welches eine einfache Steck- und Lötmontage des strahlungsemittierenden Bauelements auf einer Leiterplatte ermöglicht.

Die optische Einrichtung, z.B. in Form einer Entformungsschräge oder einer Linse, kann nunmehr im Montagegehäuse 16 angeordnet werden, wodurch sich die Herstellung weiter vereinfachen lässt.

Die Erfindung ermöglicht strahlungsemittierende Bauelemente, bei denen ohne Umlenkung eine Strahlung in senkrechter Richtung zu einer Leiterplatte erzielt werden können, auch wenn ein Sidelooker eingesetzt wird. Es kann dabei auf bekannte SMT-Gehäuse zurückgegriffen werden, die beispielsweise hinsichtlich Wärmeabfuhr optimiert sind, was diese ideal für eine Anwendung mit einem Diodenlaser macht. Die Verwendung von Produktionswerkzeugen eines SMT-Gehäuses für leistungsfähige Pulslaser ist damit möglich. Wird eine definierte Ablenkung des Strahls benötigt, wie beispielsweise bei einem Infrarot-Scheinwerfer, so könnte ein Array aus mehreren Laserdiodenbauelementen mit jeweils geänderten Entformungsschrägen an der Außenwand des Gehäusegrundkörpers oder eines eventuellen Montagegehäuses eingesetzt werden.

Bei einem Verfahren zum Herstellen eines Laserdiodenbauelements gemäß dem Ausführungsbeispiel wird zunächst ein metallischer Leiterrahmen mit einem Chipanschlußbereich und elektrischen Anschlußleitern 5a,5b bereitgestellt. Danach erfolgt ein Umformen eines Teilbereiches des metallischen Leiterrahmens einschließlich Teilbereichen der elektrischen Anschlußleiter 5a,5b mit dem Gehäusegrundkörper 1. Nach dem Montieren des Laserdiodenchips 9 in den Chipmontagebereich des Gehäusegrundkörpers 1 werden die elektrischen Kontakte des Laserdiodenchips 9 mit den elektrischen Anschlußleitern 5a,5b elektrisch verbunden. Danach wir der Laserdiodenchip 9 mit der Vergussmasse 14 umhüllt.

Bei einer bevorzugten Ausführungsform wird vor dem Umformen des Leiterrahmens mit dem Gehäusegrundkörper 1 in den Leiterrahmen ein thermisch gut leitender Chipmontagesockel 18 einmontiert, der eine Chipmontagefläche 31 aufweist, die an den Chipmontagebereich 3 grenzt. Nachfolgend wird der Laserdiodenchip 9 auf dem Chipmontagesockel 18 befestigt, der von außerhalb des Gehäusegrundkörpers thermisch anschließbar ist.

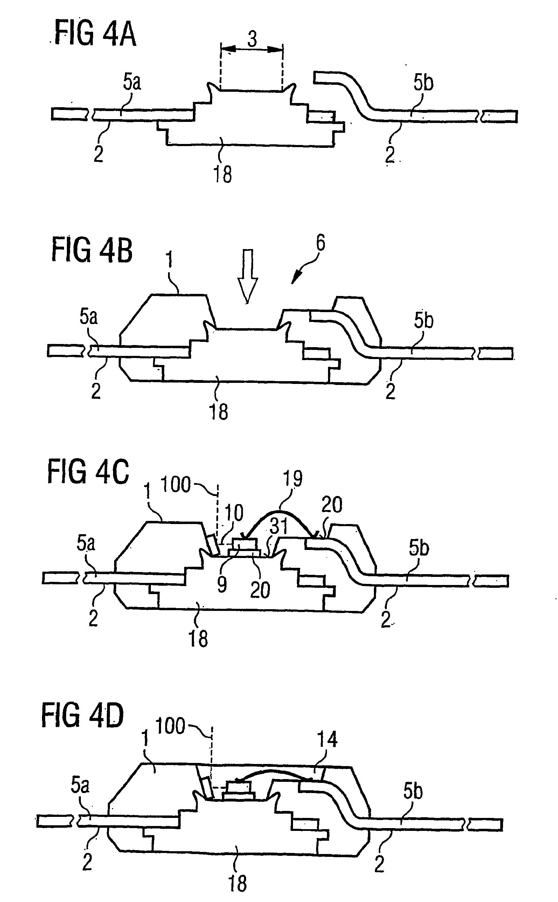

Bei dem in den Figuren 4a bis 4b schematisch dargestellten Verfahren zum Herstellen eines Laserdiodenbauelements gemäß eines nicht zur Erfindung gehörenden Ausführungsbeispiels mit einem elektrisch isolierenden Gehäusegrundkörper 1, der einen Chipmontagebereich 3 umfaßt, mit elektrischen Anschlußleitern 5a,5b, die aus dem Gehäusegrundkörper 1 herausgeführt sind und von ausserhalb des Gehäusegrundkörpers 1 zugänglich sind, und mit einem Laserdiodenchip 9, der im Chipmontagebereich 3 angeordnet ist und elektrische Kontakte aufweist, die mit den elektrischen Anschlussleitern 5a,5b elektrisch leitend verbunden sind, wird zunächst ein metallischer Leiterrahmen 2 mit elektrischen Anschlußleitern 5a,5b bereitgestellt. In einen der beiden elektrischen Anschlußleiter 5a ist ein thermisch gut leitender und als Wärmesenke fungierender Chipmontagesockel 18 aus Kupfer oder einem anderen gut wärmeleitenden metallischen Material eingeknüpft (Figur 4a).

An den Leiterrahmen 2 mit dem Chipmontagesockel 18 wird beispielsweise mittels eines Spritzgieß- oder Spritzpressverfahrens ein Gehäusegrundkörper 1 mit einer einen Chipmontagebereich 3 umfassenden Ausnehmung 6 angeformt (Figur 4b), der beispielsweise aus einem Kunststoffmaterial auf der Basis von Epoxid- oder Acrylharz besteht. Die elektrischen Anschlußleiter 5a,5b ragen auf einander gegenüberliegenden Seitenflächen des Gehäusegrundkörpers 1 aus diesem heraus. Der Chipmontagesockel 18 grenzt einerseits an die Ausnehmung 6, um den Laserdiodenchip 9 aufzunehmen, verläuft durch den Gehäusegrundkörper 1 hindurch zu dessen Rückseite hin und liegt andererseits dort frei.

Nach dem Umformen des Leiterrahmens 2 mit dem Gehäusegrundkörper 1 wird ein kantenemittierende Laserdiodenchip 9 in der Ausnehmung 6 derart auf den Chipmontagesockel 18 montiert, dass dessen Strahlachse 10 im wesentlichen parallel entlang zu einer durch eine Chipmontagefläche 31 des Chipmontagebereichs 18 definierten Ebene verläuft. Zwischen dem Laserdiodenchip 9 und dem Chipmontagesockel 18 wird vorzugsweise ein wärmeleitendes Trägerplättchen 20 aus SiC oder AlN oder einem anderen geeigneten wärmeleitenden Material angeordnet (Figur 4c).

In der Strahlachse 10 des Laserdiodenchips 9 wird vor oder nach dem Montieren des Laserdiodenchips 9 auf dem Chipmontagesockel 18 ein verspiegeltes Glasplättchen, das als Spiegelelement 17 für eine vom Laserdiodenchip 9 ausgesandte Laserstrahlung fungiert, derart in der Strahlachse 10 das Laserdiodenchips 9 und schrägstehend zu dieser an dem Gehäusegrundkörper 1 angeordnet, dass es die Laserstrahlung aus der Strahlachse 10 des Laserdiodenbauelements zur vorgesehenen Strahlachse 100 des Laserdiodenbauelements hin umlenkt (Figur 4c). Vorliegend verläuft die Strahlachse 100 des Laserdiodenbauelements im Wesentlichen senkrecht zu der durch eine Chipmontagefläche 31 des Chipmontagebereichs 3 definierten Ebene. Die Chipmontagefläche 31 ist eine in der Ausnehmung 6 freiliegende Fläche des Chipmontagesockels 18.

Zur technisch einfacheren Befestigung und Positionierung des verspiegelten Glasplättchens wird bereits bei der Herstellung des Gehäusegrundkörpers 1 an sich in der Strahlachse 10 des vorgesehenen Laserdiodenchips 9 an geeigneter Stelle an einer Seitenwand der Ausnehmung 6 eine schräg zur Strahlachse 10 des Laserdiodenchips 9 stehende ebene Fläche ausgebildet, an der nachfolgend das Glasplättchen befestigt wird.

Vor oder nach dem Montieren des Glasplättchens wird mittels mindestens einem Bonddraht 19 mindestens ein elektrischer Kontakt des Laserdiodenchips 9 mit einer in der Ausnehmung 6 freiliegenden Anschlußfläche 20 des elektrischen Anschlußleiters 5b verbunden (Figur 4c).

Schließlich wird die Ausnehmung 6 mit einer Umhüllungsmasse 14, die für eine vom Laserdiodenchip 9 im Betrieb ausgesandte Laserstrahlung durchlässig ist, vergossen. Beispielsweise kann hierzu ein einfaches Vergießen des Laserdiodenchips 9 in der Ausnehmung 6 erfolgen. Ebenso ist hierzu aber auch der Einsatz eines Spritzguss- oder Spritzpressverfahrens denkbar. Als Umhüllungsmasse 14 kann beispielsweise eine Kunststoffmaterial auf der Basis von Silikonharz oder ein anderes geeignetes Kunststoffmaterial verwendet werden.

Abschließend oder zu irgendeinem anderen geeigneten Zeitpunkt im Verfahren werden die außerhalb des Gehäusegrundkörpers liegenden Teilbereiche der Anschlußleiter 5a,5b derart geformt, dass das Laserdiodenbauelement oberflächenmontierbar ist.

## Patentansprüche

1. Laserdiodenbauelement mit einem Gehäuse und mit einem kantenemittierenden Laserdiondenchip (9),
wobei das Gehäuse
- oberflächenmontierbar ist,
- einen elektrisch isolierenden Gehäusegrundkörper (1) und elektrische Anschlußleiter (5a,5b), die aus dem Gehäusegrundkörper (1) herausgeführt sind und von ausserhalb des Gehäusegrundkörpers (1) zugänglich sind, aufweist, und der Gehäusegrundkörper (1) aus einem Material gefertigt ist, das für eine vom Laserdiodenchip (9) auszusendende Laserstrahlung durchlässig ist, und ferner
- der Gehäusegrundkörper (1) eine Ausnehmung (6) mit einem Chipmontagebereich (3) aufweist, wobei der Chipmontagebereich (3) an eine Chipmontagefläche (31) grenzt, und wobei die elektrischen Anschlußleiter (5a, 5b) zur Montage und zum elektrischen Anschliessen des Laserdiodenchips (9) durch die Ausnehmung (6) hindurch zugänglich sind,
- im Chipmontagebereich (3) der Laserdiodenchip (9) montiert ist und elektrische Kontakte des Laserdiodenchips (9) mit den elektrischen Anschlussleitern (5a,5b) elektrisch leitend verbunden sind, wobei der Laserdiodenchip (9) an die Chipmontagefläche (31) grenzt,
wobei eine Strahlachse (10) des Laserdiodenchips (9) im wesentlichen in einer Ebene parallel zu der Chipmontagefläche (31) und durch den Gehäusegrundkörper (1) verläuft.

2. Laserdiodenbauelement nach Anspruch 1,
**dadurch gekennzeichnet, dass**
eine die Ausnehmung (6) begrenzende Fläche (7) des Gehäusegrundkörpers (1), durch die die Laserstrahlung in den Gehäusegrundkörper (1) eingekoppelt wird, weitestgehend keine reflexiven oder streuenden Eigenschaften aufweist.

3. Laserdiodenbauelement nach einem der vorhergehenden Ansprüche,
**dadurch gekennzeichnet, dass**
der Gehäusegrundkörper (1) aus einem Kunststoffmaterial gebildet ist.

4. Laserdiodenbauelement nach Anspruch 3,
**dadurch gekennzeichnet, dass**
die Formmasse zumindest kurzzeitig temperaturbeständig bis 260°C ist.

5. Laserdiodenbauelement nach Anspruch 3 oder 4,
**dadurch gekennzeichnet, dass**
die Formmasse Polyethersulfon (PES) enthält.

6. Laserdiodenbauelement nach einem der vorhergehenden Ansprüche,
**dadurch gekennzeichnet, dass**
zumindest eine Aussenfläche (11) des Gehäusegrundkörpers (1) mit einer optischen Einrichtung versehen ist.

7. Laserdiodenbauelement nach Anspruch 6,
**dadurch gekennzeichnet, dass**
die optische Einrichtung eine zur Strahlachse (10) schrägstehende Fläche zur Ablenkung des Laserstrahls ist.

8. Laserdiodenbauelement nach Anspruch 7,
**dadurch gekennzeichnet, dass**
die schrägstehende Fläche eine Entformungsschräge des Gehäusegrundkörpers (1) ist.

9. Laserdiodenbauelement nach Anspruch 6,
**dadurch gekennzeichnet, dass**
die optische Einrichtung eine Linse (13) zur Erzielung einer Kollimation ist.

10. Laserdiodenbauelement nach einem der vorhergehenden Ansprüche,
**dadurch gekennzeichnet, dass**
die elektrischen Anschlussleiter (5a,5b) in Form eines metallischen Leiterrahmens ausgebildet sind.

11. Laserdiodenbauelement nach Anspruch 10,
**dadurch gekennzeichnet, dass**
der Leiterrahmen eine Chipmontagefläche umfasst, auf dem ein Laserdiodenchip (9) montierbar ist.

12. Laserdiodenbauelement nach einem der vorhergehenden Ansprüche,
**dadurch gekennzeichnet, dass**
der Laserdiodenchip (9) zumindest teilweise mit einer strahlungsdurchlässigen Umhüllungsmasse (14) umhüllt ist.

13. Laserdiodenbauelement nach dem vorhergehenden Anspruch,
**dadurch gekennzeichnet, dass**
die Umhüllungsmasse (14) ein Gießharz oder eine Kunststoff-Pressmasse ist.

14. Laserdiodenbauelement nach Anspruch 12 oder 13,
**dadurch gekennzeichnet, dass**
die Umhüllungsmasse (14) ein Epoxidharz, ein Acrylharz, ein Siliconharz oder eine Mischung dieser Harze enthält.

15. Laserdiodenbauelement nach Anspruch 12, 13 oder 14, bei **d adurch gekennzeichnet**, dass
die Materialien der Umhüllungsmasse (14) und des Gehäusegrundkörpers (1) hinsichtlich ihrer Brechungsindizes aneinander angepasst sind.

16. Laserdiodenbauelement nach einem der vorhergehenden Ansprüche,
**dadurch gekennzeichnet, dass**
das Laserdiodenbauelement in einem Montagegehäuse (16) angeordnet ist und die Materialien des Montagegehäuses (16) und des Gehäusegrundkörpers (1) hinsichtlich ihrer Brechungsindizes aneinander angepasst sind.

17. Laserdiodenbauelement nach einem der vorhergehenden Ansprüche,
**dadurch gekennzeichnet, dass**
im Gehäusegrundkörper (1) eine Mehrzahl von Laserdiodenchips angeordnet sind.

18. Laserdiodenbauelement nach dem vorhergehenden Anspruch,
**dadurch gekennzeichnet, dass**
jedem Laserdiodenchip (9) an der Aussenfläche des Gehäusegrundkörpers (1) eine Strahlumlenkschräge zugeordnet ist und mindestens zwei der Strahlumlenkschrägen voneinander verschieden sind.

19. Laser-Scheinwerfer mit einer Mehrzahl von Laserdiodenbauelementen gemäß Anspruch 7 oder gemäß einem auf diesen Anspruch zurückbezogenen Anspruch,
bei dem die schrägstehenden Flächen von mindestens zwei Gehäusen voneinander verschieden sind.

## Claims

1. Laser diode component having a housing and having an edge emitting laser diode chip (9),
wherein the housing
- is surface-mountable,
- has an electrically insulating housing basic body (1) and electrical connecting conductors (5a, 5b), which are led out from the housing basic body (1) and are accessible from outside the housing basic body (1), and the housing basic body (1) is produced from a material which is transmissive to a laser radiation to be emitted by the laser diode chip (9),
and furthermore
- the housing basic body (1) has a cutout (6) with a chip mounting region (3), wherein the chip mounting region (3) adjoins a chip mounting area (31), and wherein the electrical connecting conductors (5a, 5b), for mounting and for electrically connecting the laser diode chip (9) are accessible through the cutout (6),
- the laser diode chip (9) is mounted in the chip mounting region (3) and electrical contacts of the laser diode chip (9) are electrically conductively connected to the electrical connecting conductors (5a, 5b) wherein the laser diode chip (9) adjoins the chip mounting area (31),
wherein a beam axis (10) of the laser diode chip (9) runs essentially in a plane parallel to the chip mounting area (31) and through the housing basic body (1).

2. Laser diode component according to Claim 1,
**characterized in that**
an area (7) of the housing basic body (1) which delimits the cutout (6) and through which the laser radiation is coupled into the housing basic body (1) has to the greatest possible extent no reflective or scattering properties.

3. Laser diode component according to one of the preceding claims,
**characterized in that**
the housing basic body (1) is formed from a plastics material.

4. Laser diode component according to Claim 3,
**characterized in that**
the moulding composition is at least briefly thermostable up to 260°C.

5. Laser diode component according to Claim 3 or 4,
**characterized in that**
the moulding composition contains polyethersulfone (PES).

6. Laser diode component according to one of the preceding claims,
**characterized in that**
at least one outer area (11) of the housing basic body (1) is provided with an optical device.

7. Laser diode component according to Claim 6,
**characterized in that**
the optical device is an area situated obliquely with respect to the beam axis (10) and serving for deflecting the laser beam.

8. Laser diode component according to Claim 7,
**characterized in that**
the obliquely situated area is a mould release bevel of the housing basic body (1).

9. Laser diode component according to Claim 6,
**characterized in that**
the optical device is a lens (13) for obtaining a collimation.

10. Laser diode component according to one of the preceding claims,
**characterized in that**
the electrical connecting conductors (5a, 5b) are designed in the form of a metallic leadframe.

11. Laser diode component according to Claim 10,
**characterized in that**
the leadframe comprises a chip mounting area, on which a laser diode chip (9) can be mounted.

12. Laser diode component according to one of the preceding claims,
**characterized in that**
the laser diode chip (9) is at least partly encapsulated with a radiation-transmissive encapsulation composition (14).

13. Laser diode component according to the preceding claim,
**characterized in that**
the encapsulation composition (14) is a casting resin or a plastic moulding composition.

14. Laser diode component according to Claim 12 or 13,
**characterized in that**
the encapsulation composition (14) contains an epoxy resin, an acrylic resin, a silicone resin or a mixture of these resins.

15. Laser diode component according to Claim 12, 13 or 14,
**characterized in that**
the materials of the encapsulation composition (14) and of the housing basic body (1) are adapted to one another with regard to their refractive indices.

16. Laser diode component according to one of the preceding claims,
**characterized in that**
the laser diode component is arranged in a mounting housing (16) and the materials of the mounting housing (16) and of the housing basic body (1) are adapted to one another with regard to their refractive indices.

17. Laser diode component according to one of the preceding claims,
**characterized in that**
a plurality of laser diode chips are arranged in the housing basic body (1).

18. Laser diode component according to the preceding claim,
**characterized in that**
a beam deflecting bevel is assigned to each laser diode chip (9) at the outer area of the housing basic body (1) and at least two of the beam deflecting bevels are different from one another.

19. Laser searchlight having a plurality of laser diode components according to Claim 7 or according to a claim referred back to this claim,
in which the obliquely situated areas of at least two housings are different from one another.

## Revendications

1. Composant diode laser comprenant un boîtier et une puce de diode laser (9) à émission par les bords, le boîtier
- pouvant être monté en surface
- présentant un corps de base de boîtier (1) électriquement isolant et des conducteurs de raccordement électriques (5a, 5b) qui sortent du corps de base de boîtier (1) et qui sont accessibles depuis l'extérieur du corps de base de boîtier (1) et le corps de base de boîtier (1) étant fabriqué dans un matériau qui est transparent pour un rayonnement laser à émettre par la puce de diode laser (9), et en plus
- le corps de base de boîtier (1) présentant un creux (6) avec une zone de montage de puce (3), la zone de montage de puce (3) aboutissant contre une surface de montage de puce (31) et les conducteurs de raccordement électriques (5a, 5b) étant accessibles à travers le creux (6) pour le montage et pour le raccordement électrique de la puce de diode laser (9),
- la puce de diode laser (9) étant montée dans la zone de montage de puce (3) et les contacts électriques de la puce de diode laser (9) étant reliés électriquement avec les conducteurs de raccordement électriques (5a, 5b), la puce de diode laser (9) aboutissant contre la surface de montage de puce (31), un axe de rayon (10) de la puce de diode laser (9) s'étendant dans un plan essentiellement parallèle à la surface de montage de puce (31) et à travers le corps de base de boîtier (1).

2. Composant diode laser selon la revendication 1, **caractérisé en ce qu'**une surface (7) du corps de base de boîtier (1) qui délimite le creux (6), à travers laquelle le rayon laser est injecté dans le corps de base de boîtier (1), ne présente pour l'essentiel aucune propriété réfléchissante ou diffusante.

3. Composant diode laser selon l'une des revendications précédentes, **caractérisé en ce que** le corps de base de boîtier (1) est constitué d'une matière synthétique.

4. Composant diode laser selon la revendication 3, **caractérisé en ce que** la matière moulée est résistante à la température jusqu'à 260 °C, au moins à court terme.

5. Composant diode laser selon la revendication 3 ou 4, **caractérisé en ce que** la matière moulée contient du polyethersulfone (PES).

6. Composant diode laser selon l'une des revendications précédentes, **caractérisé en ce qu'**au moins une surface extérieure (11) du corps de base de boîtier (1) est munie d'un dispositif optique.

7. Composant diode laser selon la revendication 6, **caractérisé en ce que** le dispositif optique est une surface inclinée par rapport à l'axe de rayon (10) pour dévier le rayon laser.

8. Composant diode laser selon la revendication 7, **caractérisé en ce que** la surface inclinée est un biseau de démoulage du corps de base de boîtier (1).

9. Composant diode laser selon la revendication 6, **caractérisé en ce que** le dispositif optique est une lentille (13) destinée à obtenir une collimation.

10. Composant diode laser selon l'une des revendications précédentes, **caractérisé en ce que** les conducteurs de raccordement électriques (5a, 5b) sont réalisés sous la forme d'un cadre conducteur métallique.

11. Composant diode laser selon la revendication 10, **caractérisé en ce que** le cadre conducteur comprend une surface de montage de puce sur laquelle peut être montée la puce de diode laser (9).

12. Composant diode laser selon l'une des revendications précédentes, **caractérisé en ce que** la puce de diode laser (9) est au moins partiellement enrobée dans une masse d'enrobage (14) transparente au rayonnement.

13. Composant diode laser selon la revendication précédente, **caractérisé en ce que** la masse d'enrobage (14) est une résine de moulage ou une matière synthétique de moulage.

14. Composant diode laser selon la revendication 12 ou 13, **caractérisé en ce que** la masse d'enrobage (14) contient une résine époxyde, une résine acrylique, une résine de silicone ou un mélange de ces résines.

15. Composant diode laser selon la revendication 12, 13 ou 14, **caractérisé en ce que** les matières de la masse d'enrobage (14) et du corps de base de boîtier (1) sont adaptées les unes aux autres du point de vue de leur indice de réfraction.

16. Composant diode laser selon l'une des revendications précédentes, **caractérisé en ce que** le composant diode laser est disposé dans un boîtier de montage (16) et les matériaux du boîtier de montage (16) et du corps de base de boîtier (1) sont adaptés les uns aux autres du point de vue de leur indice de réfraction.

17. Composant diode laser selon l'une des revendications précédentes, **caractérisé en ce qu'**une pluralité de puces de diode laser est disposée dans le corps de base de boîtier (1).

18. Composant diode laser selon la revendication précédente, **caractérisé en ce qu'**un biseau de déviation du rayon est associé à chaque puce de diode laser (9) sur la surface extérieure du corps de base de boîtier (1) et au moins deux des biseaux de déviation du rayon sont différents l'un de l'autre.

19. Projecteur à laser comprenant une pluralité de composants diode laser selon la revendication 7 ou selon une revendication qui fait référence à cette revendication, selon lequel les surfaces inclinées d'au moins deux boîtiers sont différentes l'une de l'autre.
